# EUROPEAN PATENT APPLICATION

(11) **EP 4 503 450 A1**
(43) Date of publication of application: **05.02.2025**
(21) Application number: 23779259.3
(22) Date of filing: 06.03.2023
(51) Int. Cl.: H04B 1/06, H04B 1/04, H04B 7/15

(54) **RECEIVER, NOTIFICATION METHOD, AND PROGRAM**

(30) Priority: 31.03.2022 JP 2022060104
(71) Applicant: KDDI Corporation, Tokyo 163-8003 (JP)
(72) Inventor: WATANABE, Taishi, Fujimino-shi, Saitama 356-8502 (JP); OHSEKI, Takeo, Fujimino-shi, Saitama 356-8502 (JP); YAMAZAKI, Kosuke, Fujimino-shi, Saitama 356-8502 (JP)
(74) Representative: Pitchford, James Edward
(86) International application number: PCT/JP2023/008237
(87) International publication number: WO 2023/189230

(57) **Abstract**

A receiver 30 for communicating with a transmitter through relay of a wireless signal by a relay 20, the receiver 30 enabling an amplifier provided in the relay 20 to operate in a nonlinear region beyond a linear region, as a result of the receiver 30, in a case of itself being provided with a nonlinear distortion compensation function, executing notification processing S2 for notifying the relay 20 or the transmitter 10 that the nonlinear distortion compensation function is provided.

## Description

### TECHNICAL FIELD

The present invention relates to a receiver, a notification method, and a program that are for performing processing that corresponds to whether or not a receiver is provided with a nonlinear distortion compensation function in a situation where there is a relay.

### BACKGROUND ART

Conventional technologies relating to nonlinear distortion compensation of a power amplifier that is utilized in communication such as 5G (fifth generation mobile communication system) being performed on the receiving side are disclosed in PTL1 and NPL1. In PTL1 and NPL1, distortion that occurs in the power amplifier of the transmitter is compensated for on the receiver side utilizing a pilot signal.

Here, in the case where a relay is interposed between the transmitter and the receiver, it is conceivable to perform distortion compensation in the receiver similarly to when distortion occurs in the relay.

Note that a relay is a wireless relay device called a radio frequency repeater (RF repeater), and contributes to expanding the area coverage of a receiver serving as a base station and improving the communication environment of a transmitter serving as a user terminal that is located in a dead spot within the area coverage.

### CITATION LIST

### PATENT LITERATURE

PTL1: Japanese Patent Laid-Open No. 2021-507605
PTL2: Japanese Patent Application No. 2021-143374

### NON-PATENT LITERATURE

NPL1: K. Mei, J. Liu, X. Zhang, K. Cao, N. Rajatheva, and J. Wei, 'A Low Complexity Learning-Based Channel Estimation for OFDM Systems With Online Training', IEEE Transactions on Communications, vol. 69, no. 10, pp. 6722-6733, Oct. 2021

### SUMMARY OF INVENTION

### TECHNICAL PROBLEM

However, with the conventional technologies, in a situation in which distortion compensation may or may not be available (distortion compensation may or may not be set) in a plurality of receivers, consideration is not given to effectively utilizing a relay by adaptively responding to the individual situations.

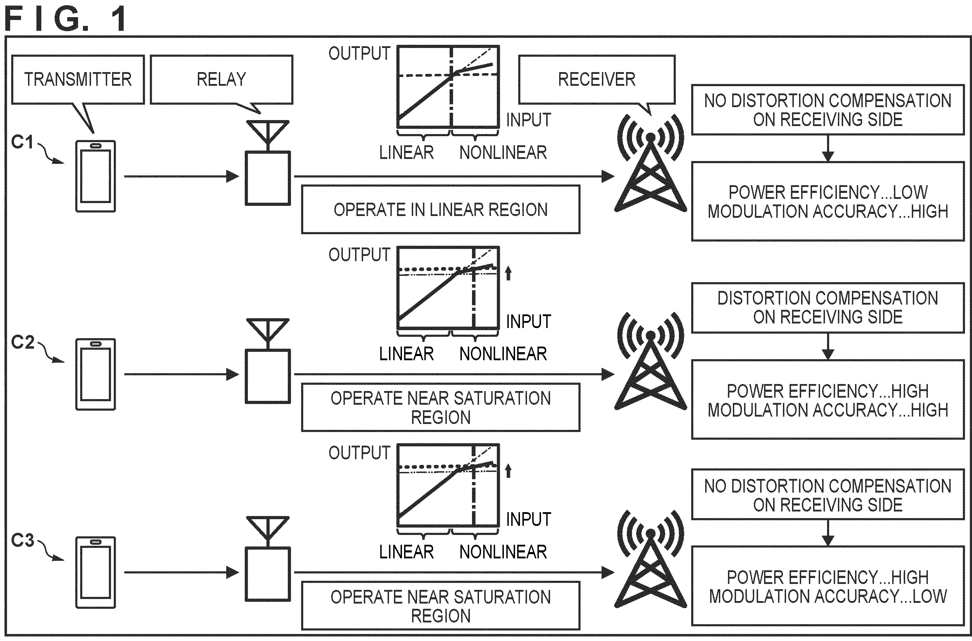

FIG. 1 is a diagram schematically showing various situations depending on whether or not distortion compensation is available, with three case scenarios, namely, cases C1 to C3, being shown. In case C1, a wireless signal from a transmitter is amplified by a relay that is set to operate in a linear region, and is then received by a receiver that is set not to perform distortion compensation. In case C1, since distortion does not occur as a result of amplification by the relay, the receiver not performing distortion compensation is not particularly an issue, but the power efficiency of the relay decreasing because of being set to operate in the linear region is an issue.

In case C2, a wireless signal from a transmitter is amplified by a relay that is set to operate near a saturation region where distortion occurs beyond the linear region, and is then received by a receiver that is set not to perform distortion compensation. In case C2, since distortion occurs as a result of amplification by the relay, the receiver performs distortion compensation, with this being advantageous in that the operating region increases compared to case C1, and the power efficiency of the relay increases.

In case C3, similarly to case C2, a wireless signal from a transmitter is amplified by a relay that is set to operate near a saturation region where distortion occurs beyond the linear region, but, unlike case C2, the receiver is set not to perform distortion compensation. Case C3 is advantageous in that the power efficiency of the relay increases similarly to case C2, but since the receiver does not perform distortion compensation, there is a problem in that modulation accuracy decreases, and performance clearly deteriorates.

As shown in the example in FIG. 1 above, even though the power efficiency of the relay improves when operated near the saturation region, the receivers are a mixture of those that support a function for performing distortion compensation and those that do not, and in the case of a receiver that does not support such a function, performance deterioration will result as shown in case C3. The conventional technologies are not able to respond adaptively to various setting situations such as the above (setting whether to increase the operating region of the relay to near the saturation region and setting whether or not to compensate for distortion in the receiver).

### SOLUTION TO PROBLEM

In view of the above problems with the conventional technologies, an object of the present invention is to provide a receiver, a notification method, and a program that are able to perform adaptive processing that depends on the mode of a distortion compensation function of the receiver in the case where a relay is provided.

In order to achieve the above mentioned object, the present invention is a receiver for communicating with a transmitter through relay of a wireless signal by a relay, the receiver enabling an amplifier provided in the relay to operate in a nonlinear region beyond a linear region, as a result of the receiver, in a case of itself being provided with a nonlinear distortion compensation function, executing notification processing for notifying the relay or the transmitter that the nonlinear distortion compensation function is provided.

### ADVANTAGEOUS EFFECTS OF INVENTION

According to the present invention, as a result of a receiver, in the case of itself being provided with a nonlinear distortion compensation function, notifying a relay or a transmitter to that effect, an amplifier provided in the relay is enabled to operate in a nonlinear region beyond the linear region, thus enabling an adaptive response that secures both the power efficiency of the relay and the modulation accuracy of the receiver to be realized.

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

The accompanying drawings, which are incorporated in and constitute a part of the specification, illustrate embodiments of the invention and, together with the description, serve to explain principles of the invention.
FIG. 1 is a diagram schematically showing various situations depending on availability of distortion compensation.
FIG. 2 is a diagram showing the configuration of a communication system according to one embodiment and a procedure that is implemented in the configuration.
FIG. 3 is a diagram showing one embodiment serving as a modification of the procedure in FIG. 2.
FIG. 4 is a diagram showing an example of the configuration of a computer provided with a wireless communication function.

### DESCRIPTION OF EMBODIMENTS

Hereinafter, embodiments will be described in detail with reference to the attached drawings. Note, the following embodiments are not intended to limit the scope of the claimed invention, and limitation is not made to an invention that requires a combination of all features described in the embodiments. Two or more of the multiple features described in the embodiments may be combined as appropriate. Furthermore, the same reference numerals are given to the same or similar configurations, and redundant description thereof is omitted.

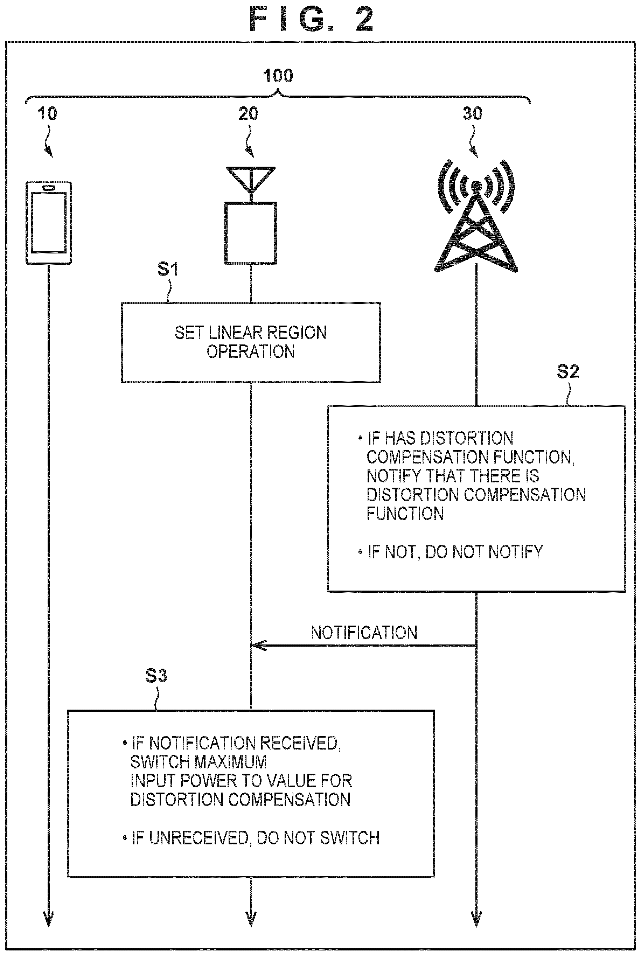

FIG. 2 is a diagram showing the configuration of a communication system 100 according to one embodiment and steps S1 to S3 of a procedure that is implemented in the configuration. The communication system 100 is part of a cellular communication system (mobile communication network) supporting 5G, for example, and includes a transmitter 10 serving as a user terminal which is a mobile communication device such as a smartphone, a relay 20 serving as a radio frequency repeater, and a receiver 30 serving as a base station device. The relay 20 may be movable by being installed in a drone or a relay vehicle. The relay 20 is not provided with a function for decoding up to data signals such as IAB (Integrated access and backhaul, which integrates a wireless access network with wireless backhaul), and need only be a device that performs AF (Amplifier and Forward) relay and is not provided with a decoding function such as a repeater, or a Network-controlled repeater provided with a function for decoding only control signals.

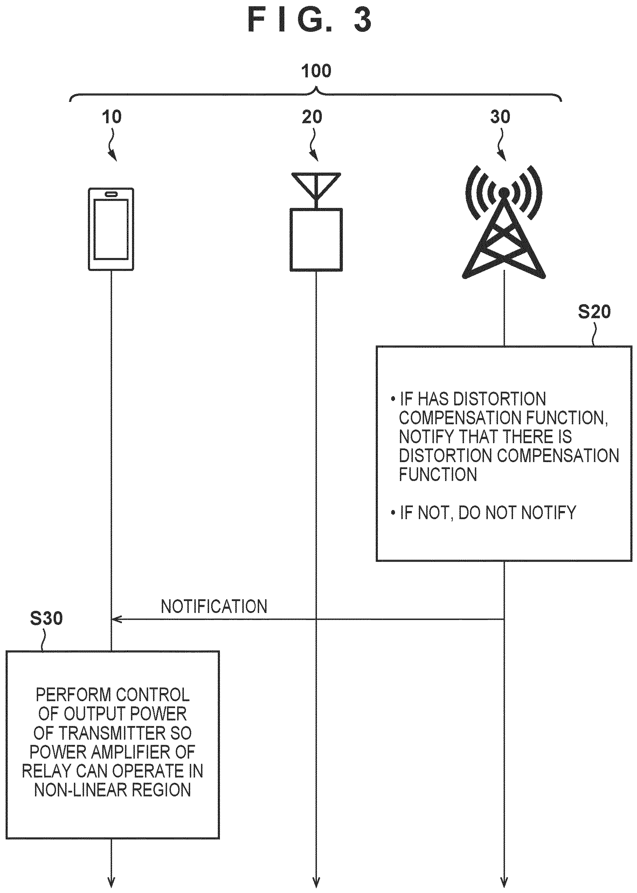

While there can be a plurality of transmitters 10, relays 20, and receivers 30, an arbitrary one of each which is capable of wireless communication with the other devices is shown in FIG. 2 out of the plurality of devices that can exist, and steps S1 to S3 are shown as a procedure that is executed between the transmitter 10, the relay 20, and the receiver 30 in the wirelessly communicable state. Hereinafter, each of steps S1 to S3 will be described. Note that a procedure in FIG. 3 is also possible as a modification of the procedure shown in FIG. 2, with the procedure in FIG. 3 being realized by omitting step S1 in FIG. 2 and respectively changing steps S2 and S3 to steps S20 and S30 in FIG. 3. Hereinafter, while describing the procedure in FIG. 2, the procedure in FIG. 3 will also be described as appropriate as a modification thereof, premised on this correspondence relationship. The operations of the relay 20 can be controlled directly or indirectly by notifying the relay 20 in the procedure in FIG. 2, and by notifying the transmitter 10 in the procedure in FIG. 3.

In step S1, as a presetting, the amplifier of the relay 20 is set to operate in the linear region. This presetting may be configured by the transmitter 10 wirelessly transmitting a control signal for causing the amplifier to operate in the linear region to the relay 20, or may be configured such that the amplifier operates in the linear region as a setting in the relay 20 itself, as long as no other control signals are received. Note that it is presumed that, in step S1, a first technique described later is applied and the relay 20 is provided with a power control function. In the procedure in FIG. 3, which is a modification of the procedure in FIG. 2, it is presumed that a second technique described later is applied, and the relay 20 is not provided with the power control function, and thus this step S1 is omitted.

In step S2, the receiver 30, in the case of itself being provided with a distortion compensation function, notifies the relay 20 to that effect (that the receiver 30 is provided with the distortion compensation function) by a wireless signal. In step S20 serving as a modification, the receiver 30, in the case of itself being provided with the distortion compensation function, notifies the transmitter 10 to the same effect (that the receiver 30 is provided with the distortion compensation function). When notifying the transmitter 10, the relay 20 need only relay the notification. The notification of steps S2 and S20 will be described in detail later as first to fourth embodiments.

Note that since the receiver 30 configured to include a computer has its own model information as fixed information, and information on provision of the distortion compensation function can be included in the model information in advance, the receiver 30 is able to automatically determine whether or not it is itself provided with the distortion compensation function, and, in the case of itself being provided therewith, perform the notification processing of step S2 or S20.

In step S3, the relay 20, having received the notification indicating that the distortion compensation function is provided from the receiver 30 in step S2 causes the amplifier to operate near the saturation region (nonlinear region beyond the linear region), by switching the maximum input power of the amplifier to a value set beforehand for use in distortion compensation (predetermined value greater than the maximum input power of the amplifier when set to operate in the linear region in step S1), as the setting for that receiver 30.

On the other hand, in step S30 serving as a modification, signal transmission (including information indicating that the receiver 30 is provided with the distortion compensation function) is performed from the receiver 30 to the transmitter 10 in step S20, and thus the transmitter 10 performs control so as to control the power of the signal that is sent on the transmitter 10 side, rather than restricting the input power on the relay 20 side. That is, the transmitter 10 controls the output power of the transmitter 10 such that the amplifier of the relay 20 is also operable in the nonlinear region, on the premise that distortion compensation will be performed when the transmission signal from the transmitter 10 is received by the receiver 30 after having been relayed by the relay 20.

Here, specifically, input to the power amplifier of the relay 20 can be controlled by one of the following two techniques, with the first technique being employed in the procedure in FIG. 2, and the second technique being employed in the procedure in FIG. 3 serving as a modification.
First Technique: The relay 20 is provided with the power control function, and controls power by internal processing of the relay 20 itself with AGC (automatic gain control) or the like.
Second Technique: The relay 20 is not provided with the power control function, and enables the behavior of the relay 20, which involves ensuring that the power of radio waves that reach the relay 20 is within the linear region of the amplifier or operating the amplifier up to and including the nonlinear region, to be changed by controlling the output power of the transmitter 10 serving as a user terminal.

In the case where the receiver 30 notifies the relay 20 in step S2 of the procedure in FIG. 2, the first technique described above is applied. On the other hand, in the case where the receiver 30 notifies the transmitter 10 in step S20 of the procedure in FIG. 3, the second technique described above is applied, and the relay 20 that receives and relays the wireless signal from this transmitter 10 performs control such that the amplifier also consequently operates in the nonlinear region, by performing control such that the output power of the transmitter 10 is controlled to be within a larger range.

In this way, according to the procedure in FIG. 2 or FIG. 3, in the case where it is determined that the receiver 30 is provided with the distortion compensation function in step S2 or S20, the relay 20 or the transmitter 10 are notified to that effect, and the amplifier of the relay 20 is operated beyond the linear region in step S3 or S30, and thus the aforementioned case C2 in FIG. 1 or the like is adaptively realized with respect to the discrete combination of the relay 20 and the receiver 30. It is thereby possible to increase the maximum input level of the amplifier of the relay 20, and the power efficiency of the relay 20 is improved, thus extending the coverage between the base station 30 and the relay 20.

Note that in the case of using the procedure in FIG. 2, in step S2, the receiver 30, in the case of not itself being provided with the distortion compensation function, does not perform the aforementioned notification, and thus, as a result of execution of step S3 being skipped, the relay 20 causes the amplifier to operate in the linear region as set in step S1. The aforementioned case C1 in FIG. 1 is thereby adaptively realized with respect to the discrete combination of the relay 20 or the like and the receiver 30. Similarly, in the case of using the procedure in FIG. 3 serving as a modification, in step S20, the receiver 30, in the case of not itself being provided with the distortion compensation function, does not perform the aforementioned notification, and thus, as a result of execution of step S30 being skipped, the relay 20 causes the amplifier to operate in the linear region.

Hereinafter, first to fourth embodiments in which the receiver 30 performs notification indicating that it is itself provided with the distortion compensation function in step S2 or S20 will be described.

In the first embodiment, provision of the distortion compensation function in the receivers 30 is immutable (i.e., for each individual receiver 30, whether or not the distortion compensation function is provided is determined according to the individual model of that receiver 20), and thus can be set in the RRC (Radio Resource Control) configuration in the relay 20 or the transmitter 10. Note that, as a result of a relay (network-controlled repeater) capable of processing such as decoding with regard to control signals being used for the relay 20, information to this effect can be set in the RRC configuration, with similar processing to a transmitter 10 serving as a user terminal provided with a decoding function.

With the RRC configuration, it is possible to manage whether the relay 20 or the transmitter 10 is in a connected state of being connected to the receiver 30 or in a standby state of not being connected to the receiver 30, and thus when transitioning to the connected state, the receiver 30 need only notify information about whether or not it is itself provided with distortion compensation to the relay 20 or the transmitter 10.

Note that with regard to provision of the distortion compensation function, the default setting is off (i.e., the relay 20 is set in step S1 to operate the amplifier in the linear region assuming the receiver 30 is not provided with the distortion compensation function), and, if a setting notification indicating that distortion compensation is provided in the RRC configuration in step S2, the relay 20, in step S3, can be set to increase the maximum input level (voltage).

In the second embodiment, the receiver 30 is able to notify the relay 20 or the transmitter 10 that it is itself provided with the distortion compensation function with a PDCCH (Physical Downlink Control Channel). As is well known, a PDCCH is a channel that performs 5G communication between the receiver 30 (base station) and the transmitter 10 (terminal) or between the receiver 30 and the relay 20, and is used in downlink L1/L2 control signaling.

Specifically, for example, information on provision of the distortion compensation function may be added in DCI (Downlink Control Information) format which is defined in the above-mentioned PTL2 filed by the applicant. In PTL2, as a result of DCI including an instruction indicating a beam pattern to be formed by a relay 20 (wireless repeater) capable of dynamic beam control being transmitted to the relay 20 by a receiver 30 (base station), an optimal beam pattern is notified to the relay 20 when the relay 20 performs relay between a transmitter 10 (user terminal) and the receiver 30, and information on provision of the distortion compensation function in the receiver 30 need only be added to this DCI as additional information. An example of the DCI format of PTL2 is, for example, a format that includes format type, destination, beam instruction, and slot timing, and information on provision of the distortion compensation function may be further added thereto.

In the third embodiment, the receiver 30 is able to notify the relay 20 or the transmitter 10 that it is itself provided with the distortion compensation function with a MAC-CE (Media Access Control-Control Element). As is well known, a MAC-CE is defined as a control signal for controlling the MAC (Media Access Control) layer, and in the second embodiment and the third embodiment, information on provision of the distortion compensation function in the receiver 30 need only be added to this control signal.

In the fourth embodiment, the relay 20 is assumed to be provided with a power level detection function, and the receiver 30, in the case of itself being provided with the distortion compensation function, transmits a wireless signal of a preset specific level to the relay 20, and the relay 20, in the case of determining, with the power level detection function, that a predetermined level (this predetermined level can be stored in advance as corresponding to the specific level with consideration for attenuation over distance, etc.) corresponding to the specific level exists in the wireless signal received from the receiver 30, is able to determine that notification indicating that the receiver 30 is provided with the distortion compensation function has been received. Here, power level detection need only be determined by performing level averaging over a certain period of time, or determined by a level average or a moving average over a specific period (processing such as taking the average of three seconds pervious every second).

Note that the first to third embodiments of the above first to fourth embodiments are premised on the relay 20 being provided with a smart repeater function, that is, a function for demodulating received wireless signals (control information, etc.), and the relay 20 is able to obtain information indicating that the relay 30 is provided with the distortion compensation function, by demodulating wireless signals received from the receiver 30. The fourth embodiment does not require the demodulation function of the relay 20.

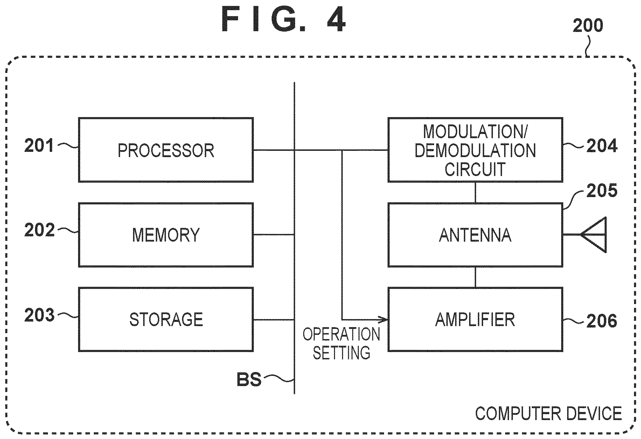

FIG. 4 is a diagram showing an example of a configuration of a computer device 200 provided with a wireless communication function, and the transmitter 10, the relay 20, and the receiver 30 in the wireless communication system 100 can each be realized as a device having all or part of the configuration of the computer device 200.

The computer device 200 includes a processor 201 constituted by a CPU (and GPU) and the like, a memory 202 serving as a temporary storage device that provides a work area to the processor 201, a storage 203 serving as a secondary storage device, a modulation/demodulation circuit 204, an antenna 205, an amplifier 206, and a bus BS that connects these devices in a manner that allows for communication of digital data therebetween.

The processor 201 executes the respective processing (relating to digital processing) of the transmitter 10, the relay 20, and the receiver 30 in each of the embodiments described above, by executing a predetermined program stored in the storage 203 and loaded into the memory 202. That is, in the receiver 30, the processor 201, in the case of determining in step S2 that the receiver 30 is provided with a nonlinear distortion compensation function, executes, as a predetermined program, processing for notifying the relay 20 that the receiver 30 is provided with this function, nonlinear distortion compensation processing, and the like. Also, in the relay 20, the processor 201 executes, as a predetermined program, processing for configuring settings so as to cause the amplifier 206 to operate in the linear region in advance in step S1, processing for causing the amplifier 206 to also operate in the nonlinear region in step S3 upon receiving the notification from the receiver 30, and the like.

The antenna 205 may be constituted to include a plurality of antennas, and may be capable of configuring a plurality of beam patterns by switching the antennas that are used. The modulation/demodulation circuit 204 modulates and demodulates wireless signals that are transmitted and received from the antenna 205.

In the present embodiment, the amplifier 206 is provided in the case of realizing the relay 20 with the computer device 200, and amplifies wireless signals that are received from the antenna 205, by causing output signals obtained by taking the wireless signals as input signals and amplifying these signals to be transmitted from the antenna 205. The amplifier 206 is configured to be capable of switching settings between operating in the linear region or also operating the nonlinear region, by receiving instructions from the processor 201 via the bus BS.

The communication system 100 of the present embodiment improves the power efficiency of the relay 20, thereby enabling the coverage between the base station 30 and the relay 20 to be extended, and thus being able to contribute to infrastructure development of information and communication technologies. It is thereby possible to contribute to Goal 9 of the Sustainable Development Goals (SDGs) spearheaded by the United Nations, which is to "build resilient infrastructure, promote inclusive and sustainable industrialization, and foster innovation". The present invention is not limited to the above embodiments, and various changes and modifications are possible without departing from the spirit and scope of the present invention. Accordingly, the following claims are appended, in order to disclose the scope of the invention.

The present application claims priority to Japanese Patent Application No. 2022-060104 filed on March 31, 2022, and the entire content thereof is incorporated herein by reference.

## Claims

1. A receiver for communicating with a transmitter through relay of a wireless signal by a relay,
the receiver enabling an amplifier provided in the relay to operate in a nonlinear region beyond a linear region, as a result of the receiver, in a case of itself being provided with a nonlinear distortion compensation function, executing notification processing for notifying the relay or the transmitter that the nonlinear distortion compensation function is provided.

2. The receiver according to claim 1,
wherein the notification processing is executed when setting a radio resource control (RRC) for managing whether the relay or the transmitter is in a connected state of being connected to the receiver or whether the relay or the transmitter is in a connection standby state.

3. The receiver according to claim 1,
wherein the notification processing is executed by including information indicating that the receiver is provided with the nonlinear distortion compensation function in downlink control information (DCI) to be transmitted from the receiver to the relay or the transmitter.

4. The receiver according to claim 1,
wherein the notification processing is executed by including information indicating that the receiver is provided with the nonlinear distortion compensation function in a control signal of a media access control-control element (MAC-CE).

5. The receiver according to any one of claims 1 to 4,
wherein the relay is provided with a power control function, and
the amplifier is configured to operate in the nonlinear region beyond the linear region, as a result of the notification processing being executed with respect to the relay, and the relay, having received the notification, switching to a setting that increases a maximum input voltage of the amplifier with use of the power control function.

6. The receiver according to any one of claims 1 to 4,
wherein the relay is not provided with a power control function, and
the amplifier in the relay that relays the wireless signal transmitted from the transmitter is configured to operate in the nonlinear region beyond the linear region, as a result of the notification processing being executed with respect to the transmitter, and the transmitter, having received the notification, performing control to increase an output voltage.

7. The receiver according to claim 1,
wherein the notification processing is executed with respect to the relay, and
the notification processing is executed by causing the relay to determine that notification indicating that the receiver is provided with the nonlinear distortion compensation function has been received, in a case where the receiver transmits a wireless signal of a specific level to the relay, and the relay determines that a wireless signal of a predetermined level corresponding to the specific level has been received.

8. The receiver according to claim 1,
wherein the amplifier provided in the relay is set in advance to operate in the linear region, and
as a result of the notification processing being skipped in a case where the receiver is not provided with the nonlinear distortion compensation function, a setting by which the amplifier provided in the relay operates in the linear region is continued.

9. A notification method for execution by a receiver that communicates with a transmitter through relay of a wireless signal by a relay,
the method enabling an amplifier provided in the relay to operate in a nonlinear region beyond a linear region, as a result of the receiver, in a case of itself being provided with a nonlinear distortion compensation function, executing notification processing for notifying the relay or the transmitter that the nonlinear distortion compensation function is provided.

10. A program for causing a computer to function as a receiver that communicates with a transmitter through relay of a wireless signal by a relay,
the program enabling an amplifier provided in the relay to operate in a nonlinear region beyond a linear region, as a result of the receiver, in a case of itself being provided with a nonlinear distortion compensation function, executing notification processing for notifying the relay or the transmitter that the nonlinear distortion compensation function is provided.
